# EUROPEAN PATENT APPLICATION

(11) **EP 3 859 773 A1**
(43) Date of publication of application: **04.08.2021**
(21) Application number: 19866359.3
(22) Date of filing: 12.09.2019
(51) Int. Cl.: H01L 23/12, H01L 23/06, H01L 23/36, H05K 1/02

(54) **WIRING BOARD AND ELECTRIC DEVICE**

(30) Priority: 27.09.2018 JP 2018182272
(71) Applicant: Kyocera Corporation, Kyoto-shi, Kyoto 612-8501 (JP)
(72) Inventor: MATSUMOTO,Yuhei, Kyoto-shi, Kyoto 612-8501 (JP); OKAMOTO,Kazuhiro, Kyoto-shi, Kyoto 612-8501 (JP); KITABAYASHI,Aki, Kyoto-shi, Kyoto 612-8501 (JP); YAMAMOTO,Sentarou, Kyoto-shi, Kyoto 612-8501 (JP); FURUKUBO,Youji, Kyoto-shi, Kyoto 612-8501 (JP)
(74) Representative: Viering, Jentschura & Partner mbB Patent- und Rechtsanwälte
(86) International application number: PCT/JP2019/035929
(87) International publication number: WO 2020/066665

(57) **Abstract**

A wiring board including: a frame base material 1; and a metal member 3, wherein the frame base material 1 is formed in plate-shaped, and includes a through hole 1b in a central region 1a of the frame base material 1, the metal member 3 includes a stage part 3a and at least one bridge part 3b, a width of the bridge part 3b is equal to or narrower than a width of the stage part 3a, the bridge part 3b extending toward an outer side from the stage part 3b, the stage part 3b is arranged to be fit to the through hole 1b, and the bridge part 3b is arranged to be disposed facing the frame base material 1.

## Description

### Field

The present disclosure relates to a wiring board and an electric device.

### Background

Conventionally, as a wiring board for mounting thereon electric elements such as a semiconductor element and a light emitting element, there has been proposed a structure having a metal heat radiation member arranged in a region in which electric elements are provided, so as to diffuse heat generated by these electric elements (see Patent Literature 1, for example).

### Citation List

### Patent Literature

Patent Literature 1: Japanese Patent Application Laid-open No. H04-125953

### Summary

### Solution to Problem

A wiring board according to the present disclosure includes: a frame base material; and a metal member, wherein the frame base material is formed in plate-shaped, and includes a through hole in a central region of the frame base material, the metal member includes a stage part and at least one bridge part, a width of the bridge part is equal to or narrower than a width of the stage part, the bridge part extending toward an outer side from the stage part, at least a part of the stage part is arranged to be exposed from the through hole, and the bridge part is arranged to be disposed facing the frame base material.

In an electric device according to the present disclosure, an electric element is mounted on a wiring board.

### Brief Description of Drawings

FIG. 1 is a perspective view illustrating a wiring board according to the present disclosure viewed from a side of one of its principal surfaces.
FIG. 2 is a perspective view illustrating the wiring board illustrated in FIG. 1 viewed from a side of the other of the principal surfaces, which is opposite to the one principal surface illustrated in FIG. 1.
FIG. 3 is an exploded perspective view illustrating the wiring board illustrated in FIG. 2.
FIG. 4 is a cross-sectional view taken along a line iv-iv illustrated in FIG. 1.
FIG. 5 is a cross-sectional view taken along a line v-v illustrated in FIG. 1.
FIG. 6 is a perspective view illustrating another mode of the wiring board according to the present disclosure.
FIG. 7 is a cross-sectional view taken along a line vii-vii illustrated in FIG. 6.
FIG. 8 is an enlarged cross-sectional view illustrating a portion P1 illustrated in FIG. 7.
FIG. 9 is a cross-sectional view taken along a line ix-ix illustrated in FIG. 6.
FIG. 10 is an exploded perspective view illustrating the wiring board illustrated in FIG. 6.
FIG. 11 is a perspective view illustrating another mode of the wiring board according to the present disclosure.
FIG. 12 is a partially-exploded perspective view illustrating the wiring board illustrated in FIG. 10.
FIG. 13 is a perspective view illustrating another mode of the wiring board according to the present disclosure.
FIG. 14 is an exploded plan view illustrating layers of the wiring board illustrated in FIG. 13.
FIG. 15 is a perspective view illustrating another mode of the wiring board according to the present disclosure.
FIG. 16 is a partially-exploded perspective view illustrating an electric device according to the present disclosure.
FIG. 17 is a perspective view illustrating a sample of another wiring board.
FIG. 18 is a perspective view illustrating a sample of another wiring board.
FIG. 19 is a perspective view schematically illustrating a method for evaluating heat dissipation of the sample.
FIG. 20 is a cross-sectional view schematically illustrating a method for evaluating rigidity of the sample. Description of Embodiments

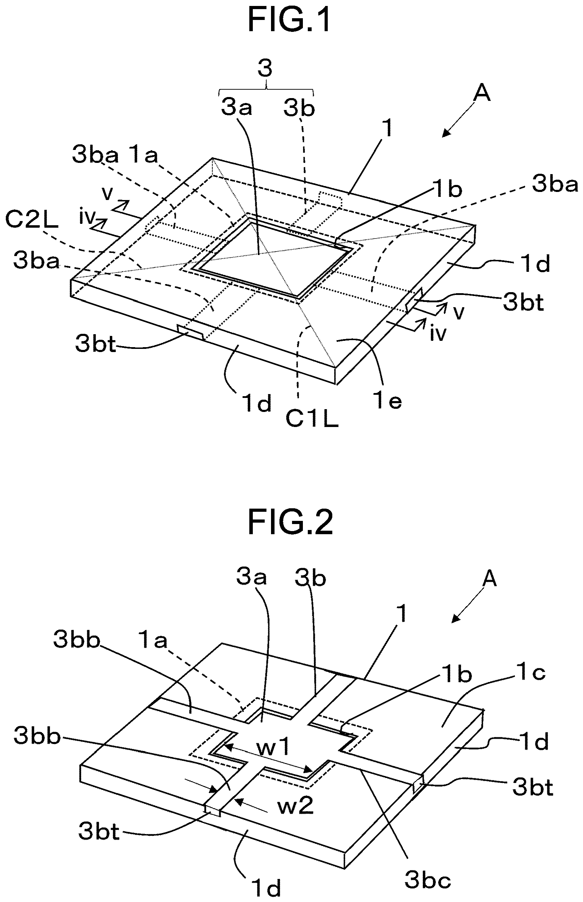

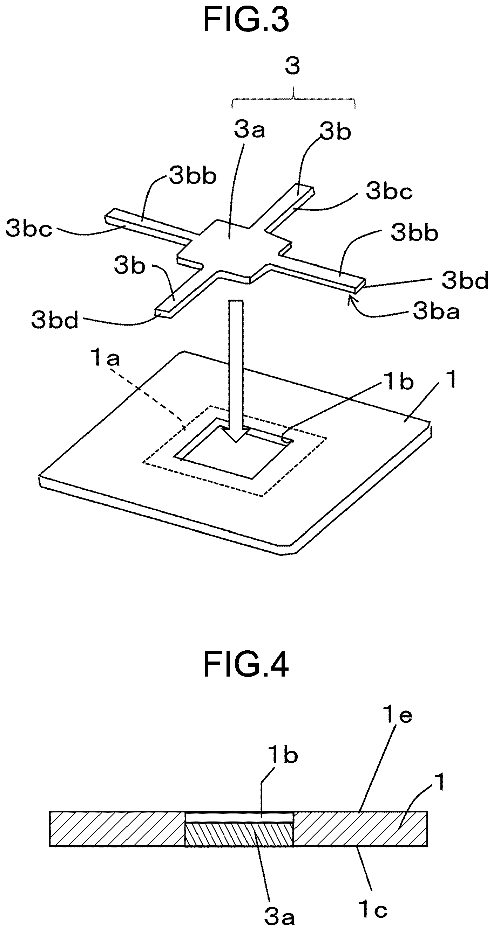

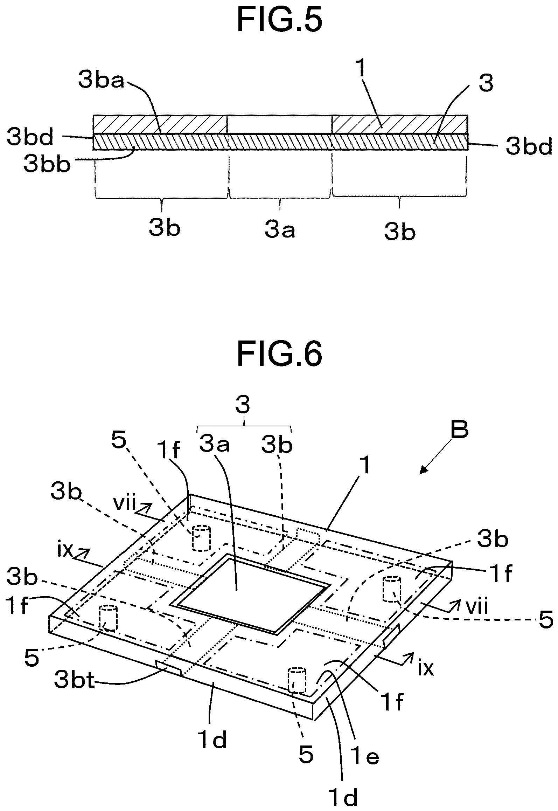

FIG. 1 is a perspective view illustrating a wiring board A according to the present disclosure viewed from a side of one of its principal surfaces. FIG. 2 is a perspective view illustrating the wiring board A illustrated in FIG. 1 viewed from a side of the other of the principal surfaces, which is opposite to the one principal surface illustrated in FIG. 1. FIG. 3 is an exploded perspective view illustrating the wiring board A illustrated in FIG. 2. FIG. 4 is a cross-sectional view taken along a line iv-iv illustrated in FIG. 1. FIG. 5 is a cross-sectional view taken along a line v-v illustrated in FIG. 1. In FIG. 5, dashed lines in a part corresponding to a metal member 3 are illustrated for convenience of explanation in order to clarify that the metal member 3 is constituted of a stage part 3a and bridge parts 3b.

The wiring board A according to embodiments includes a frame base material 1 and the metal member 3. Hereinafter, the frame base material 1 constituting the wiring board A may be referred to as the first frame base material 1. The first frame base material 1 is formed in plate-shaped. In a plan view, the first frame base material 1 includes a through hole 1b in its central region 1a (see dashed line). The central region 1a is a region surrounding an intersection point of two diagonal lines C1L and C2L in a case where the first frame base material 1 is formed in rectangular-shaped as illustrated in FIGS. 1 and 2. An area of the central region 1a has an arbitrary size because it depends on a size of an electric element to be mounted; however, roughly speaking, may be 0.1 to 0.3 when an area of a right face 1e to be mentioned later of the first frame base material 1 is one.

The metal member 3 includes the stage part 3a and the bridge parts 3b. In this case, widths of the bridge parts 3b are equal to a width of the stage part 3a, or widths of the bridge parts 3b are narrower than a width of the stage part 3a. When widths of the bridge parts 3b are equal to a width of the stage part 3a, a portion outer than the through hole 1b is the bridge parts 3b. The stage part 3a and the bridge parts 3b are preferably integrated with each other. In a case of the wiring board A illustrated in FIGS. 1 and 2, the metal member 3 is in a state where the stage part 3a and the bridge parts 3b are exposed to a side of one (in FIG. 2, surface on which metal member 3 is laminated; hereinafter, may be referred to as reverse face 1c) of principal surfaces of the first frame base material 1. The bridge parts 3b extend in a plurality of directions from the stage part 3a. In the wiring board A according to the present embodiment, the bridge parts 3b extend respective four directions from the stage part 3a. Thus, the first frame base material 1 is divided into four regions by the bridge parts 3b.

Herein, sizes and shapes of the stage part 3a and the bridge parts 3b will be explained. In FIGS. 1 and 2, an area of the stage part 3a is illustrated to be smaller than an opened area of the through hole 1b. Note that as described below, a stage part 1a may be covered with a portion of the frame base material 1. Sizes of the stage part 3a and the through hole 1b are changed in FIGS. 1 and 2 for convenience of explanation so that they are able to be distinguished from each other. In this case, the stage part 3a may be preferably arranged such that at least a portion thereof is exposed from the through hole 1b. In a plan view of the first frame base material 1, an area of a principal surface of the stage part 3a may preferably have a size corresponding to an area of the through hole 1b that is provided in the first frame base material 1. A size of an area of a principal surface of the stage part 3a, which corresponds to an area of the through hole 1b that is provided in the first frame base material 1, means that an area of the stage part 3a may be equal to an area of the through hole 1b provided in the first frame base material 1, or an area of the stage part 3a may be within a range of equal to or more than 0.90 and equal to or less than 1.1 in a case where an area of the through hole 1b is one. In this case, it is preferable that a shape of the stage part 3a and a shape of the through hole 1b may be nearly similar to each other. The stage part 3a may be arranged to be fitted to the through hole 1b.

Next, as illustrated in FIG. 2, it is preferable that a width of the bridge parts 3b is narrower than a width of the stage part 3a, in other words, when a width of the stage part 3a is defined as w1 and a width of the bridge parts 3b is defined as w2, w1 and w2 are in a relation of w1 > w2. In this case, a shape of the stage part 3a in a plan view may be preferably square; however, not limited thereto, may be rectangular-shaped with a plurality of corners as long as the shape corresponds to the through hole 1b provided in the first frame base material 1. In this case, corners of the stage part 3a in a plan view may be rounded.

The bridge part 3b may be formed in rectangular-shaped. As illustrated in FIGS. 1 and 2, the bridge parts 3b extend in outer directions from the stage part 3a. The bridge parts 3b are arranged to be flush with the reverse face 1c of the first frame base material 1. Moreover, an end part 3bt of the bridge part 3b, which is opposite to the stage part 3a, is exposed on a side surface 1d of the first frame base material 1. Hereinafter, a principal surface of the first frame base material 1 which is opposite to the reverse face 1c may be defined as the right face 1e.

In the wiring board A, the stage part 3a constituted of the metal member 3 is arranged in the through hole 1b of the first frame base material 1. Principal surfaces of the stage part 3a are exposed to both sides of the right face 1e and the reverse face 1c of the first frame base material 1. Therefore, heat of the stage part 3a is able to be emitted from both of the surfaces of the stage part 3a. Thus, it is possible to improve heat dissipation from the wiring board A.

As described above, the bridge parts 3b that are integrated with the stage part 3a are provided to the wiring board A. Moreover, the bridge parts 3b are exposed on the reverse face 1c of the first frame base material 1. Thus, it is possible to additionally execute heat dissipation from the bridge parts 3b.

A heat radiation member such as a heatsink may be arranged in contact with the exposed bridge part 3b. Thus, it is possible to further improve heat dissipation of the wiring board A.

In a case of the wiring board A, the first frame base material 1 has a structure to be segmented by the bridge parts 3b extending, from the stage part 3a, in respective directions that are perpendicular to each other. In other words, the first frame base material 1 has a structure to be held by the bridge parts 3b extending, from the stage part 3a, in respective four directions. Thus, it is possible to improve flatness of the wiring board A. In this case, a width w2 of the bridge part 3b is narrower than a width w1 of the stage part 3a. Thus, on the first frame base material 1, there presents a region in a periphery of the stage part 3a, which is not covered with the bridge parts 3b. An elastic modulus of the wiring board A in the region that is not covered with the bridge parts 3b is lower than that of a region that is covered with the bridge parts 3b by an amount corresponding to the non-covering bridge parts 3b. As a result, even when a distortion occurs in the wiring board A, the first frame base material 1 is easily deformed in the region where the bridge part 3b is not present. Thus, it is possible to reduce the stress that occurs in the wiring board A. As a result, in a case where the wiring board A has a structure to be mounted on a mother board or the like, high connection reliability is able to be obtained. In this case, an elastic modulus of the first frame base material 1 is able to be lower than that of the metal member 3, and thus the first frame base material 1 may be formed of a material whose main component is organic resin. When the first frame base material 1 is formed of a material whose main component is organic resin, it is preferable that electric conductive paste containing organic resin is applied to via electric conductors 5 and wiring parts 13, which are to be mentioned later. In this case, as a metal component contained in the electric conductive paste, at least one noble-metal material that is selected from a group of gold, silver, palladium, and platinum is preferable because reduction thereof in the electric conductivity due to oxidation is small.

Next, shapes of the bridge parts 3b constituting the metal member 3 will be more specifically explained. As illustrated in FIGS. 1 to 5, each of the bridge parts 3b includes a first principal surface 3ba, which is in contact with the first frame base material 1, and a second principal surface 3bb that is opposite to the first principal surface 3ba. In this case, the second principal surface 3bb is a principal surface that is not in contact with the first frame base material 1. As illustrated in FIG. 3, each of the bridge parts 3b includes a side surface 3bc that is connected with the first principal surface 3ba and the second principal surface 3bb. The side surface 3bc of the bridge part 3b is arranged in a lateral direction (width direction) of the bridge part 3b. Moreover, each of the bridge parts 3b includes an edge surface 3bd at its edge on a side opposite to the stage part 3a.

According to the wiring board A, each of the bridge parts 3b includes, in addition to the second principal surface 3bb that is not in contact with the first frame base material 1, a surface that is not in contact with the first frame base material 1 on the edge surface 3bd that is an edge of the corresponding bridge part 3b in its longitudinal direction, so that it is possible to further improve heat dissipation of the bridge parts 3b.

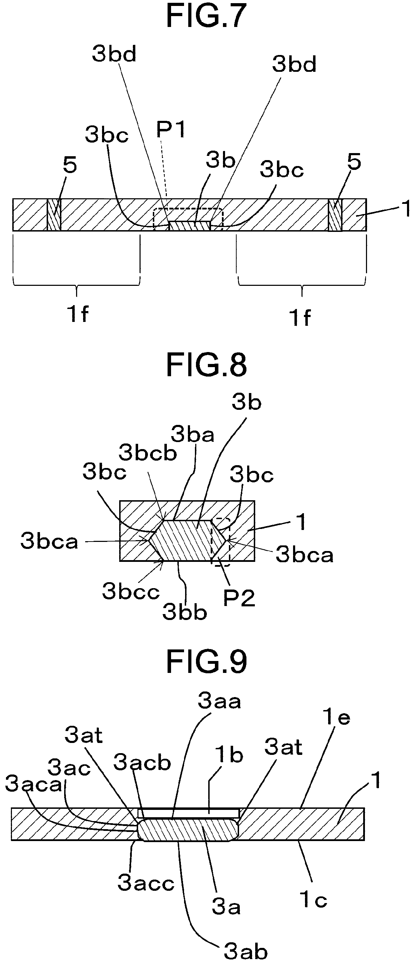

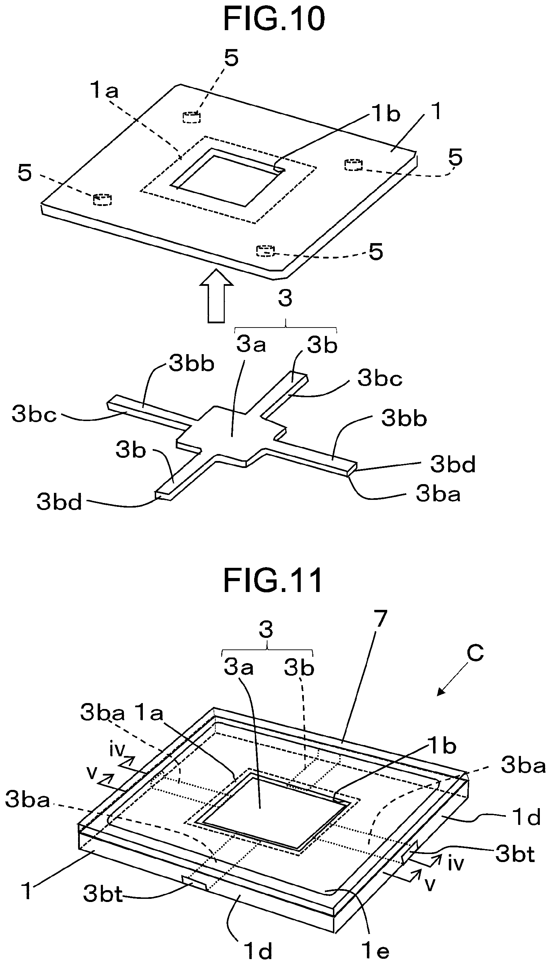

FIG. 6 is a perspective view illustrating another mode of the wiring board according to the present disclosure. A wiring board B illustrated in FIG. 6 is obtained by providing the via electric conductors 5 to the wiring board A illustrated in FIG. 1. FIG. 7 is a cross-sectional view taken along a line vii-vii illustrated in FIG. 6. FIG. 8 is an enlarged cross-sectional view illustrating a portion P1 illustrated in FIG. 7. FIG. 9 is a cross-sectional view taken along a line ix-ix illustrated in FIG. 6. FIG. 10 is an exploded perspective view illustrating the wiring board illustrated in FIG. 6. In a wiring board according to the embodiments, it is preferable that the frame base material 1 includes the via electric conductor 5 in at least one of regions divided by the bridge parts 3b. In the wiring board B, the first frame base material 1 includes the via electric conductors 5 in respective four regions segmented by the bridge parts 3b. In FIG. 6, the regions segmented by the bridge parts 3b are provided with a reference symbol of 1f, and are regions each of which is surrounded by long dashed dotted lines. Regions 1f segmented by the bridge parts 3b are regions in which the first frame base material 1 is not covered with the bridge parts 3b.

In other words, in the wiring board B, the via electric conductors 5 are arranged in regions in which the first frame base material 1 is not overlapped with the bridge parts 3b. In this case, the via electric conductors 5 penetrates through the first frame base material 1 in a thickness direction thereof.

As illustrated in FIG. 6, each of the via electric conductors 5, which penetrates through the first frame base material 1 in a thickness direction thereof, is arranged in a position that is closer to the stage part 3a than the side surface 1d of the first frame base material 1 constituting the wiring board B. Thus, heat that is generated in a side of one of principal surfaces of the wiring board B is able to be transferred to an opposite side from the via electric conductor 5 arranged in a position close to the stage part 3a. In other words, in the wiring board B, heat that is generated in a side of one of principal surfaces of the wiring board B is able to be transferred to an opposite side via a shorter detour and not via the side surface 1d of the first frame base material 1 from a principal surface of the stage part 3a. Furthermore, it is possible to transmit, via a shorter route, an electric signal from a side of one of principal surfaces of the wiring board B to the other principal surface thereof on an opposite side. Thus, it is possible to obtain a wiring board having a low inductance.

In the above-mentioned wiring boards A and B, the bridge parts 3b may be embedded in the first frame base material 1. In this case, in the bridge part 3b, a center portion 3bca in a thickness direction thereof on the side surface 3bc may protrude in a width direction thereof from a corresponding position 3bcb on a surface of the metal member 3 and a corresponding position 3bcc on a reverse face of the position 3bcb.

In other words, in a cross-sectional view, the bridge parts 3b may have a shape obtained by removing a corner portion 3bd between the first principal surface 3ba or the second principal surface 3bb opposite thereto and the side surface 3bc. Particularly, the center portion 3bca in a thickness direction of the bridge parts 3b may be acute-shaped. In this case, in the bridge part 3b, a part in which the center portion 3bca in a thickness direction thereof protrudes in a width direction thereof from the position 3bcb on the first principal surface 3ba and the position 3bcc on the second principal surface 3bb that is a reverse face may be formed not only on one side of the side surface 3bc of the bridge part 3b, but also on the two side surfaces 3bc directing opposite sides. Note that the width direction of the bridge part 3b indicates a direction connecting two side surfaces 3bca illustrated in FIG. 8.

In a case where the side surface 3bc of the bridge part 3b has a shape obtained by removing the corner portion 3bd between the side surface 3bc and at least one of the first principal surface 3ba and the second principal surface 3bb, when the bridge part 3b is embedded in the first frame base material 1, an acute part (reference symbol P2) of the bridge part 3b is in a state where it penetrates into the first frame base material 1. Thus, the bridge part 3b is hardly peeled from the first frame base material 1 even in a state where the bridge part 3b is embedded near a surface of the first frame base material 1.

Moreover, as illustrated in FIG. 9, a side surface of the stage part 3a may have a shape protruding in its width direction similarly to the bridge part 3b. Specifically, a center portion 3aca in a thickness direction of a side surface 3ac of the stage part 3a may have a shape protruding its width direction from a position 3acb on a first principal surface 3aa of the stage part 3a and a position 3acc on a second principal surface 3ab that is on a reverse-face side. When the stage part 3a has such a shape illustrated in FIG. 9, an end part 3at of the stage part 3a may be covered with a part of the first frame base material 1. In this case, it is preferable that the whole portion around the stage part 3a in the end part 3at of the stage part 3a is covered with a part of the first frame base material 1. When the end part 3at of the stage part 3a has a structure that is covered with a part of the first frame base material 1, the stage part 3a arranged in the through hole 1b of the first frame base material 1 is fixed to the through hole 1b by the part of the first frame base material 1. Thus, the stage part 3a is further hardly separated from the through hole 1b. In this case, the end parts 3at of the stage part 3a may be covered with a part of the first frame base material 1 from both sides (1d, 1e) in the thickness direction.

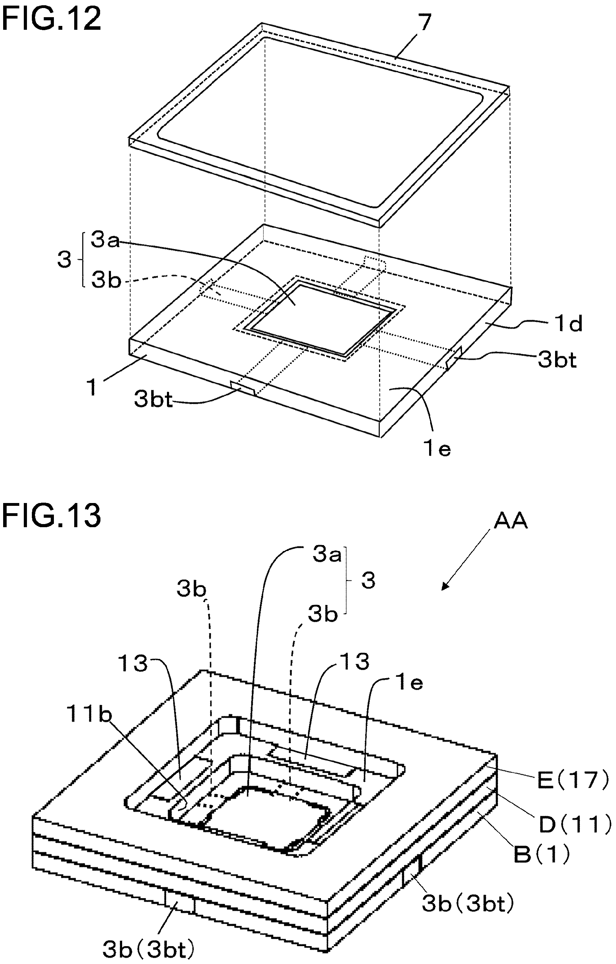

FIG. 11 is a perspective view illustrating another mode of the wiring board according to the present disclosure. FIG. 12 is an exploded perspective view illustrating the wiring board illustrated in FIG. 11. As illustrated in FIG. 12, a wiring board C is able to be separated into the wiring board A and a metal frame member 7. The metal frame member 7 is bonded to at least the right face 1e of the frame base material 1 constituting the wiring board A. The right face 1e of the frame base material 1, which is bonded to the metal frame member 7, is a surface opposite to the reverse face 1c form which the bridge parts 3b are exposed. In this case, the metal frame member 7 may be bonded up to the side surface 1d of the frame base material 1. As illustrated in FIG. 11, in a case of a structure in which the metal frame member 7 is bonded to the wiring board A, it is possible to suppress a warp of the wiring board C. In a case of a structure in which the bridge parts 3b are exposed from the reverse face 1c of the frame base material 1 as illustrated in the wiring board A, there presents a case where the reverse face 1c of the wiring board A is convexly deformed and further the right face 1e is concavely deformed. The wiring board C is capable of preventing such a warp to be generated in the wiring board A.

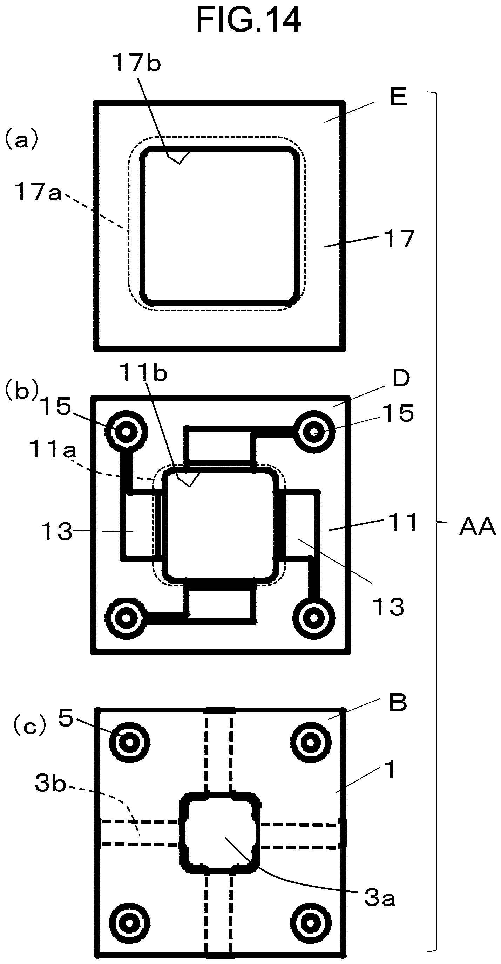

FIG. 13 is a perspective view illustrating another mode of the wiring board according to the present disclosure. FIG. 14 is an exploded plan view illustrating layers of a wiring board AA illustrated in FIG. 13. The wiring board AA illustrated in FIG. 13 has a structure in which a plate-shaped frame member 11 that includes a through hole 11b in its central region 11a is further laminated on the wiring board B. In this case, the above-mentioned wiring board B is a basic layer of the wiring board AA. The wiring board AA includes a wiring board D and a base-material layer E on or above the wiring board B. The wiring board D includes a frame base material 11 and the wiring parts 13. The frame base material 11 constituting the wiring board D may be referred to as the second frame base material 11. The base-material layer E is constituted of a frame base material 17. Hereinafter, the frame base material 17 constituting the base-material layer E may be referred to as the third frame base material 17. The second frame base material 11 includes the through hole 11b in the central region 11a thereof. The third frame base material 17 also includes a through hole 17b in its central region 17a.

In a case of the wiring board AA, areas of opening parts of the through hole 1b that is formed in the first frame base material 1 constituting the wiring board B, the through hole 11b that is formed in the second frame base material 11 constituting the wiring board D, and the through hole 17b that is formed in the third frame base material 17 constituting the base-material layer E increase step-by-step from a lower-layer side of the first frame base material 1 to an upper-layer side of the third frame base material 17. In other words, sizes of openings of the through holes 1b, 11b, and 17b increase step-by-step from a side of the stage part 3a to the upward side. Thus, it is preferable for a wiring board in which a light emitting element that diffuses light, such as a Light Emitting Diode (LED), is mounted on the stage part 3a.

In the wiring board AA, the wiring parts 13 are arranged in a periphery of the through hole 11b. In a case of the wiring board D illustrated in FIGS. 13 and 14, the wiring parts 13 may be arranged outer than respective sides of the through hole 11b.

The wiring board D also includes via electric conductors 15 penetrating through the second frame base material 11 in its thickness direction. The via electric conductors 15 are arranged in the respective regions 1f that are segmented by the bridge parts 3b of the wiring board B. Moreover, the via electric conductors 15 is electrically connected to the wiring parts 13. Moreover, when the wiring board B and the wiring board D are laminated, the via electric conductors 5 of the wiring board B and the via electric conductors 15 of the wiring board D are electrically connected in their lamination direction.

In the wiring board AA, even in a case of a structure in which the above-mentioned wiring board AA includes the plurality of via electric conductors 5 and 15 in their lamination direction, the via electric conductors 5 and 15 are arranged in the respective regions 1f segmented by the bridge parts 3b, and even in a case of a structure in which the plurality wiring board B and the wiring board D is laminated on the wiring board A so as to increase its thickness, it is still possible to maintain a low rigidity.

In the wiring board AA, an upper part of the stage part 3a has a cavity structure. Thus, an electric element arranged in the stage part 3a hardly receives a mechanical damage. Moreover, the wiring board AA has a structure in which the wiring board D and the base-material layer E are laminated not on a side of the reverse face 1c from which the bridge parts 3b of the wiring board B is exposed, but on a side a reverse face 1e that is opposite to the reverse face 1c, and thus heat dissipation is easily executed from the bridge parts 3b along with the stage part 3a that is exposed in the through hole 1b. As a result, it is possible to maintain a higher heat dissipation compared with a wiring board having a structure in which the stage part 3a alone is exposed.

Although not illustrated in FIGS. 13 and 14, a bonding material is provided to a periphery of the through hole 17b which is an upper surface of the base-material layer E if necessary. The bonding material is for bonding to a lid part and the like. In this case, in the wiring board AA, the metal frame member 7 may be arranged on an upper surface of the base-material layer E. Thus, it is possible to reduce a warp similarly to the case of the wiring board A.

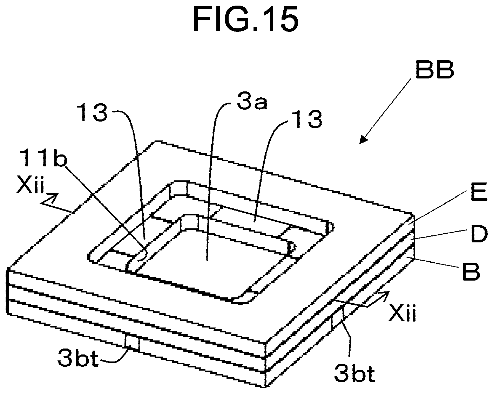

FIG. 15 is a perspective view illustrating another mode of the wiring board according to the present disclosure. A different point between a wiring board BB illustrated in FIG. 15 and the wiring board AA illustrated in FIG. 13 is that an opening area of the through hole 11b that is formed in the second frame base material 11 constituting the wiring board D is approximately equal to an area of the stage part 3a in the wiring board B. Herein, the areas indicate an area of the stage part 3a in the wiring board B in a plan view of the wiring board BB and an area of the through hole 11b in the wiring board D in a plan view of the wiring board BB. In the wiring board BB illustrated in FIG. 15, an area of the through hole 11b in the wiring board D is set to approximately equal to an area of a stage part 3b in the wiring board B, and thus it is possible to obtain a structure in which the through hole 11b of the wiring board D more tightly surrounds the stage part 3a. The wiring board BB having such a structure is preferable for mounting thereon a light emitting element whose emitted light hardly diffuses in the stage part 3a and radiates in the vertical direction. As such a light emitting element, a Laser Diode (LD), a Vertical Cavity Surface Emitting LASER (VICSEL), and the like are exemplified.

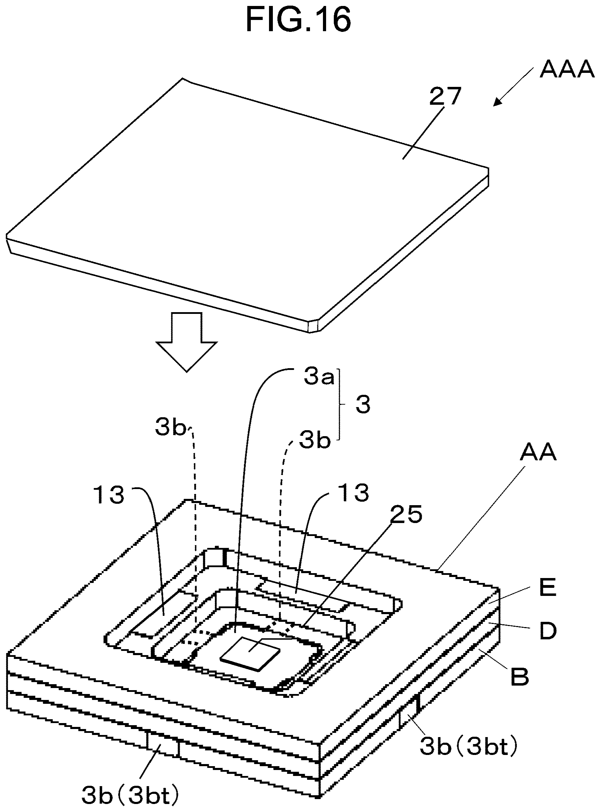

FIG. 16 is a partially-exploded perspective view illustrating an electric device according to the present disclosure. An electric device AAA includes an electric element 25 on the stage part 3a provided at a center portion of the wiring board AA. The electric device AAA includes a lid part 27 on an upper surface of the base-material layer E in the wiring board AA. A basic layer of the electric device AAA illustrated in FIG. 16 is, i.e. the wiring board A in which the bridge parts 3b along with the stage part 3a are exposed from the reverse face 1c of the first frame base material 1. In the wiring board AA constituting the electric device AAA, the wiring parts 13 arranged on a surface of the wiring board D is used for electrical connection to the electric element 25 on the stage part 3a of the wiring board D. In this case, wire bonding is commonly employed for electric connection (not illustrated) between the electric element 25 and the wiring parts 13.

When the electric element 25 is an integrated circuit such as an LSI, a substrate made of kovar or ceramic may be employed for the lid part 27. When the electric element 25 is a light emitting element, a transparent member such as a glass plate may be employed for the lid part 27 for transmitting therethrough light generated by the light emitting element. In this case, as the light emitting element, one selected from a group of a Light Emitting Diode (LED), a Laser Diode (LD), and a Vertical Cavity Surface Emitting LASER (VICSEL), and the like is preferable.

The electric device AAA illustrated in FIG. 16 may be also provided with a heat radiation member such as a heatsink. Similarly to the case of the above-mentioned wiring board A, a side of the reverse face 1c of the first frame base material 1, from which both of the stage part 3a and the bridge parts 3b are exposed, is preferable for a position in which a heat radiation member is arranged for the reason of improvement in thermal conductivity.

Next, with reference to FIG. 10, a manufacturing method of the wiring board B as one example will be explained. When fabricating the wiring board B, first, a base material to be the first frame base material 1 is prepared. Additionally, metallic foil to be the metal member 3 is prepared.

The first frame base material 1 is obtained by forming holes for the through hole 1b and the via electric conductors 5 in the base material by punching of a die, for example. The through hole 1b is formed in the central region 1a of the first frame base material 1. Holes are formed in a periphery of the through hole 1b in the first frame base material 1. The holes are formed by punching of a die or a LASER process.

The base material is sheet-shaped and contains organic resin, and preferably is in semi-cured state. The organic resin preferably contains, as a main component, one selected from a group of epoxy resin, poly phenylene ether resin, olefin resin, and the like. Herein, the main component indicates a component whose content ratio is the highest of components contained in the base material.

Commonly, the first frame base material 1 obtained from a base material is in a state where the plurality of first frame base materials 1 is connected with each other. Furthermore, the metal member 3 obtained from metallic foil is in a state where the plurality of metal members 3 is connected with each other. The plurality of first frame base materials 1 that is connected with each other is defined as a mother base material. The plurality of the metal members 3 that is connected with each other is defined as a mother metal member.

The metal members 3 (or mother metal member) is obtained by performing pattern processing on metallic foil with a method such as etching. For the metallic foil, copper foil may be preferably employed because copper foil has a high electric conductivity and pattern processing is able to be performed on copper foil with a high size accuracy. Metal paste may be preferably employed for the via electric conductors 5.

Next, the mother base material and the mother metal member are laminated, and the first frame base material 1 and the metal member 3 are overlapped with each other so as to form a temporary laminated body. In this case, the metal member 3 is arranged such that the stage part 3a is arranged on the through hole 1b formed in the first frame base material 1, and the bridge parts 3b are regions that do not cover the via electric conductors 5 formed in the first frame base material 1. Next, a pressure heat treatment is executed on the temporary laminated body under a predetermined condition so as to fabricate a laminated body to be a mother wiring board. Finally, the laminated body is cut into a piece having a predetermined size so as to obtain the wiring board B.

Next, a manufacturing method of the wiring board AA as an example will be explained with reference to FIG. 14. When fabricating the wiring board AA, first, the metal member 3 is prepared along with base materials to be the wiring board B, the wiring board D, and the base-material layer E. In this case, it is preferable that the via electric conductors 5 and 15 and the wiring parts 13 are preliminarily formed in base materials to be the wiring board B and the wiring board D. For example, electric conductive paste may be employed for formation of the via electric conductors 5 and 15 and the wiring parts 13. The via electric conductors 5 and 15 and the wiring parts 13 are formed by printing electric conductive paste on a mother base material.

Specifically, the wiring board D is obtained by forming the through hole 11b and the via electric conductors 15 in the second frame base material 11 obtained by processing a base material, and then forming the wiring parts 13 on one of its principal surfaces. The third frame base material 17, which is obtained by forming the through hole 17b in a base material, is used for the base-material layer E. In this case, for example, a mother base material in which the plurality of first frame base materials 1 is connected may be used instead of the first frame base material 1. Similarly, mother base materials may be respectively used for the second frame base material 11 and the third frame base material 17.

Next, base materials to be the wiring board B, the wiring board D, and the base-material layer E are aligned, along with the through holes 1b, 11b, and 17b, in a lamination direction of the via electric conductors 5 and 15, and then a pressure heat treatment is executed thereon under a condition similar to that of the wiring board B. In this way, there is obtained the wiring board AA.

When fabricating the electric device AAA, first, the above-mentioned wiring board AA is prepared, and then the electric element 25 is mounted on the stage part 3a of the wiring board AA. Next, with the use of bonding material, the lid part 27 is bonded to an upper surface of the base-material layer E that is an uppermost layer of the wiring board AA. It is preferable that the electric element 25 may be mounted on the stage part 3a or the lid part 27 may be bonded to an upper surface of the base-material layer E, with the use of a bonding material such as an organic resin represent by an epoxy resin, etc. or a low melting-point metal material represent by a solder or a gold-tin.

According to the above-mentioned manufacturing method, it is possible to obtain the wiring board B, the wiring board AA, and the electric device AAA having a high heat dissipation and a small residual stress.

### Practical Example

First, a base material was prepared whose main component was epoxy resin. Slurry was molded by the doctor blade method so as to fabricate a plate-shaped base material. Next, holes for through holes and via electric conductors were formed in the base material so as to fabricate a mother base material in which a plurality of frame base materials was formed. Holes for the via electric conductors, which were formed in the frame base material, were filled with an electric conductive paste whose main component was silver so as to form the via electric conductors.

An etching treatment was performed on a copper foil whose thickness was 200 µm so as to fabricate a metal member. Center portions in thickness directions of side surfaces of a stage part and bridge parts, which constituted the obtained metal member, had protruding shapes. A process was performed on the copper foil so as to obtain a shape of a mother metal member in which a plurality of metal members was connected.

Next, the fabricated mother base material and the fabricated mother metal member were laminated and pressurized heating was performed thereon so as to fabricate a mother wiring board that includes hundred wiring boards. A condition of the pressurized heating was that the maximum temperature was 200°C, pressure was 0.1 MPa, and a heating time interval was 5 hours. Next, the mother wiring board was cut into pieces each having the following size so as to fabricate the wiring board illustrated in FIGS. 1 and 2.

Regarding a size of the frame base material, a depth was 10 mm, a width was 10 mm, and a thickness was 0.3 mm. An area of a stage part in the metal member had a depth of 5 mm and a width of 5 mm. The bridge parts had a width of 1 mm. The bridge parts extended in four directions from a stage part to be exposed from opposing side surfaces of the frame base material. A periphery portion of the stage part and the bridge parts were in a state where they were covered with a part of the frame base material.

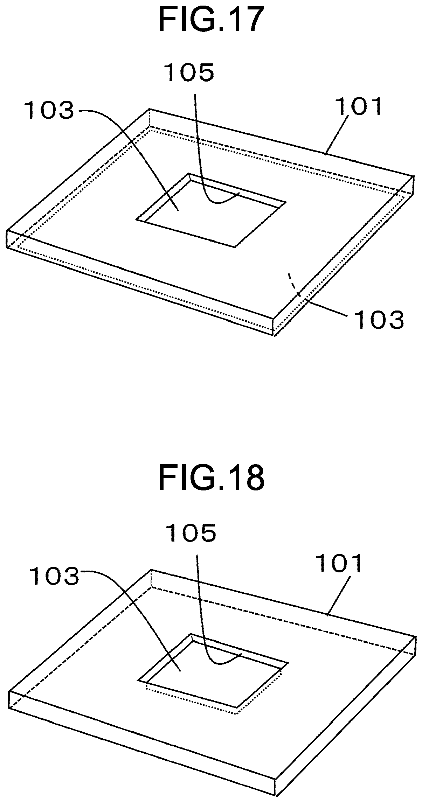

As illustrated in FIG. 17, as a sample to be a comparison example, a sample obtained by sticking copper foil on the whole of a principal surface of the frame base material was fabricated. As illustrated in FIG. 18, as another sample to be a comparison example, a wiring board including a metal member having a shape without bridge parts was fabricated. Reference symbols illustrated in FIGS. 17 and 18 indicate the following members. 101: Frame member, 103: Copper foil, 105: Through hole.

The metal member without bridge parts was fabricated by the following process. First, a metal member having bridge parts was stuck on an organic film. Next, a stage part was coated with a resist film made of an epoxy resin. Next, an etching treatment was performed on a part of the bridge parts in the metal member, which was not covered with the resist film, so as to fabricate the metal member.

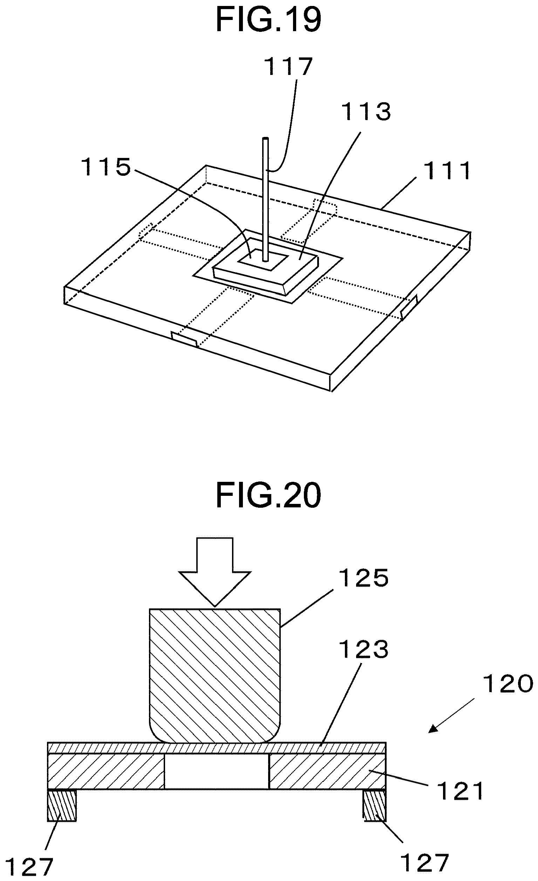

A method for evaluating heat dissipation is illustrated in FIG. 19. Reference symbols illustrated in FIG. 19 indicate the following members. 111: Wiring board, 113: Semiconductor element, 115: Alumina substrate, 117: Thermocouple. Next, a sample for measuring heat dissipation was fabricated. An alumina substrate whose thickness was 0.2 mm was placed on a surface of a semiconductor element for test, a thermocouple was arranged on its upper surface and further was fixed by using potting resin so as to fabricate the sample for measuring heat dissipation.

Heat dissipation was evaluated by the following method. First, electric current of 10 W was caused to flow into a semiconductor element (4 mm × 4 mm × 0.5 mm) for test in the atmosphere of 25°C for one minute. Next, the electric conduction was stopped, and after 10 seconds, a temperature (°C) of the surface of the semiconductor element was measured by using a thermocouple. Table 1 indicates a relative ratio when a temperature difference between a temperature (maximum temperature) of Sample No.3 and 25°C is one.

FIG. 20 illustrates a method for indicating rigidity of a wiring board. Reference symbols illustrated in FIG. 20 indicate the following members. 120: Wiring board, 121: Frame base material, 123: Metal member, 125: Pressure jig, 127: Spacer. A pressure jig was attached to an autogragh machine and the center portion of a wiring board was pressured so as to evaluate rigidity of the wiring board. In this case, the maximum stress was obtained from stress-strain characteristics. In this case, a frame body whose size of an outer frame was 10 mm × 10 mm and width and thickness were 1 mm was arranged, as a spacer 127, under a wiring board of a sample. In Table 1, a relative ratio is indicated when the maximum stress of Sample 3 is one. Heat dissipation and rigidity indicated in Table 1 were calculated from an average value of values obtained by measuring 10 pieces for each of the samples.

**Table 1**

| Sample No. | Structure of Wiring Board | Heat Dissipation | Rigidity |
|---|---|---|---|
| | | Relative Ratio of Temperature | Relative Ratio of Maximum Stress |
| 1 | FIG. 1 (FIG. 2) | 0.9 | 0.6 |
| 2 | FIG. 18 | 0.4 | 0.2 |
| 3 | FIG. 17 | 1 | 1 |

As obvious from Table 1, compared with Sample No.3 fabricated by sticking copper foil on the approximately whole of one of principal surfaces of a first frame base material, heat dissipation of Sample No.1, which was fabricated by using a metal member including a stage part and bridge parts, reduced by 10%; however, compared with Sample No.2 that is fabricated by using a metal member including a stage part alone and without bridge parts, heat dissipation of Sample No.1 was high. Sample No.1 includes a region that was not covered with the bridge part so as to have a structure in which via electric conductors were able to be arranged near the semiconductor element. Thus, it contributed to reduction in the inductance. In this point, Sample No.3 had a structure in which copper foil was stuck on the approximately whole of one of principal surfaces of the first frame base material, and thus wiring from a semiconductor element to a reverse face of the wiring board was to go through a side-surface wire formed in a periphery of the wiring board by using a bonding wire, thereby leading to increase in the inductance. Compared with Sample No.3, rigidity of a wiring board of Sample No.1 is low, and thus thermal stress in the wiring board was inclined to be eased. Compared with Sample No.3, connection reliability of Sample No.1 when a wiring board was mounted on a mother board was high.

### Reference Signs List

- A, B, C, D, AA, BB: Wiring board
- AAA: Electric device
- E: Base-material layer
- 1: Frame base material (First frame base material)
- 1a,: 11a, 17a Central region
- 1b,: 11b, 17b Through hole
- 1c: Reverse face
- 1d: Side surface
- 1e: Right face
- 1f: Region segmented by bridge parts
- 3: Metal member
- 3a: Stage part
- 3at: End part of stage part
- 3b: Bridge part
- 3ba: First principal surface
- 3bb: Second principal surface
- 3bc: Side surface
- 3bd: Corner portion
- 3bt: Edge surface
- 5, 15: Via electric conductor
- 7: Metal frame member
- 11: Second frame base material
- 13: Wiring part
- 17: Third frame base material
- 25: Electric element
- 27: Lid part

## Claims

1. A wiring board comprising:
a frame base material; and
a metal member, wherein
the frame base material is formed in plate-shaped, and includes a through hole in a central region of the frame base material,
the metal member includes a stage part and at least one bridge part,
a width of the bridge part is equal to or narrower than a width of the stage part, the bridge part extending toward an outer side from the stage part,
at least a part of the stage part is arranged to be exposed from the through hole, and
the bridge part is arranged to be disposed facing the frame base material.

2. The wiring board according to claim 1, wherein
the bridge part includes an edge surface at an edge opposite to the stage part, and
the edge surface is exposed on a side surface of the frame base material.

3. The wiring board according to claim 1 or 2, wherein
the bridge parts extend in a plurality of directions from the stage part, and
the frame base material includes a via electric conductor in at least one of regions segmented by the bridge parts.

4. The wiring board according to any one of claims 1 to 3, wherein
the bridge parts extend in four directions from the stage part, and
the frame base material includes a via electric conductor in each of four regions segmented by the bridge parts.

5. The wiring board according to any one of claims 1 to 4, wherein
the bridge part includes:
a first principal surface that is in contact with the frame base material;
a second principal surface that is opposite to the first principal surface; and
a side surface that is connected with the first principal surface and the second principal surface, the side surface being arranged in a width direction of the bridge part, and
a center portion of the side surface of the bridge part in a thickness direction between the first principal surface and the second principal surface protrudes in the width direction of the bridge part from the first principal surface and the second principal surface.

6. The wiring board according to any one of claims 1 to 5, wherein
the bridge part is embedded in the frame base material.

7. The wiring board according to any one of claims 1 to 6, wherein
a periphery portion of the stage part is covered with the frame base material.

8. The wiring board according to any one of claims 1 to 7, wherein
a plate-shaped frame member including a through hole in a central region thereof is further laminated on the wiring board.

9. An electric device, wherein
an electric element is mounted on the wiring board according to any one of claims 1 to 8.
